(19) **Europäisches Patentamt**

**European Patent Office**

**Office européen des brevets**

(11) **EP 0 932 110 B1**

(12) **FASCICULE DE BREVET EUROPEEN**

(45) Date de publication et mention
de la délivrance du brevet:
**19.02.2003 Bulletin 2003/08**

(51) Int Cl.⁷: $G06F\ 17/50$

(21) Numéro de dépôt: **98400134.7**

(22) Date de dépôt: **22.01.1998**

(54) **Procédé d'évaluation de performances de circuits à très haute intégration**

Verfahren zur Leistungsbewertung von VLSI-Schaltungen

Method for evaluating the performance of VLSI circuits

(84) Etats contractants désignés:
**DE FR GB IT**

(43) Date de publication de la demande:
**28.07.1999 Bulletin 1999/30**

(60) Demande divisionnaire:
**01109830.8 / 1 128 292**

(73) Titulaire: **BULL S.A.**
**78430 Louveciennes (FR)**

(72) Inventeur: **Thill, Michel**
**78340 Les Clayes sous Bois (FR)**

(56) Documents cités:
**US-A- 5 481 695      US-A- 5 502 644**
**US-A- 5 555 506      US-A- 5 568 395**
**US-A- 5 687 088**

- **TAKAYASU SAKURAI ET AL: "SIMPLE EXPRESSIONS FOR INTERCONNECTION DELAY, COUPLING AND CROSSTALK IN VLSI'S" VLSI DESIGN AND CAD, SINGAPORE, JUNE 11 - 14, 1991, vol. 4, no. SYMP. 24, 11 juin 1991, pages 2375-2378, XP000302885 INSTITUTE OF ELECTRICAL AND ELECTRONICS ENGINEERS**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

Le domaine de l'invention est celui de l'analyse de performance de circuits électriques. Les composantes de l'analyse de performance considérées dans le cadre de l'invention sont plus particulièrement la détermination de la vitesse à laquelle un circuit, ou un élément de circuit, peut générer des signaux de sortie à partir de signaux d'entrée.

Un circuit de traitement numérique est habituellement constitué de bascules mémorisant un état stable de signaux et de portes logiques reliant ces bascules au moyen de conducteurs électriques, de façon à réaliser des combinaisons logiques de ces signaux. Des fronts d'horloges provoquent l'émission de ces signaux en sortie de bascules et leur réception en entrée d'autres bascules. Suite à l'émission de signaux en sortie de bascules sur un front d'horloge, il est nécessaire que les entrées des autres bascules en aval aient commuté sur un état stable avant le front suivant d'horloge. L'instant de commutation sur l'entrée d'une autre bascule dépend de la vitesse à laquelle se propagent les signaux à travers les portes logiques et sur les conducteurs qui les relient entre elles et aux bascules. Cette vitesse, et donc l'instant de commutation, dépend du temps de commutation propre à chaque porte et des caractéristiques d'impédance des conducteurs: résistance, inductance et capacité. La connaissance de l'instant de commutation le plus tardif suite à un front d'horloge permet de déterminer la plus courte période d'horloge admissible par le circuit. Si la période d'horloge est imposée et que la durée qui sépare un front d'horloge de l'instant de commutation en entrée d'une bascule est supérieure à une période d'horloge, il est nécessaire de modifier la structure du circuit de façon à réduire cette durée en deçà de la période d'horloge.

Quand bien même les signaux circulent-ils et se combinent-ils rapidement d'une bascule de mémorisation à l'autre, il convient que les valeurs obtenues soient le moins erronées possible. Les valeurs de résistance, d'inductance et de capacité des éléments d'un circuit sont obtenues dans une liste de connectique (netlist en anglais) à partir des éléments topologiques contenus dans les masques de réalisation du circuit. Par exemple, la résistance d'un conducteur est directement proportionnelle à sa longueur et inversement proportionnelle à sa section. L'inductance d'un conducteur est généralement négligeable à l'intérieur d'un circuit intégré. Les effets capacitifs demandent des précautions particulières car pour chaque conducteur, ils dépendent des surfaces de ce conducteur en regard de surfaces d'autres conducteurs, des distances qui séparent ces surfaces et des variations de charges électriques sur ces autres conducteurs. Or, combinés à la résistance du conducteur, les effets capacitifs constituent un facteur déterminant de la constante de temps de ce conducteur.

Pour déterminer de façon simple cette constante de temps, il est d'usage de ramener l'effet de toutes les capacités entre conducteurs à celui d'une capacité unique entre le conducteur considéré et un conducteur de potentiel fixe, c'est à dire un conducteur ne subissant pas de variation de charge.

Dans un passé encore récent, les circuits intégrés étaient réalisés au moyen de superpositions de couches conductrices, semi-conductrices et isolantes d'épaisseur suffisamment faibles pour que les effets capacitifs sur un conducteur considéré du circuit subissant des variations de charges, soient essentiellement ceux provoqués par les capacités entre le conducteur considéré et les conducteurs de potentiel fixe, constitués par la masse et le ou les conducteurs d'alimentation en puissance du circuit. Il suffisait alors d'additionner ces capacités considérées en parallèle pour les ramener à une capacité équivalente par rapport au substrat du circuit. On pouvait affiner la valeur de cette capacité en y ajoutant purement et simplement les capacités de couplage avec les autres conducteurs. Ces autres conducteurs, à potentiel variable pour véhiculer des signaux, avaient des capacités de couplage qui représentaient en tout état de cause des quantités négligeables. L'approximation était satisfaisante.

La connaissance de cette capacité par rapport à un potentiel fixe et de la résistance du conducteur permettait aisément de déterminer une constante de temps fonction du produit de la capacité par la résistance, sur chaque conducteur considéré. On en déduisait alors aisément le ou les instants de commutation des signaux véhiculés par ce conducteur.

L'évolution actuelle des technologies de dépôts multicouches pour réaliser des circuits intégrés permet d'augmenter l'épaisseur des couches conductrices dans une direction perpendiculaire à la surface du circuit et de diminuer corrélativement l'épaisseur des conducteurs dans le plan de la surface du circuit sans diminuer la section de ces conducteurs, et donc sans en augmenter la résistance électrique, voire en la diminuant. Ceci permet d'augmenter considérablement la densité d'intégration d'éléments par unité d'aire. D'autre part, l'augmentation d'épaisseur des couches isolantes diminue considérablement la capacité de couplage entre chaque conducteur considéré et les conducteurs à potentiel fixe. L'effet des capacités de couplage entre conducteurs à potentiel variable ne représente plus une quantité négligeable devant celui des capacités de couplage avec les conducteurs à potentiel fixe mais au contraire une quantité prédominante. L'approximation décrite dans le paragraphe précédent n'est plus satisfaisante.

La diaphonie est le phénomène physique qui, dans un conducteur électrique considéré, provoque une variation de charge liée à une variation de charge dans un autre conducteur ayant une capacité de couplage avec le conducteur considéré et qui, réciproquement provoque dans ledit autre conducteur, une variation de charge liée à une variation de charge dans le conducteur considéré. Les approximations connues de l'état de la technique, pourraient conduire à une surestimation ou à une sous estimation des constantes de temps propres à chaque conducteur. Une surestimation risquerait de faire conclure qu'un circuit apte à fonctionner ne fonctionne pas. Une sous estimation risquerait de ne pas détecter l'inaptitude d'un circuit à fonctionner. On pourrait envisager de déterminer des constantes de temps pour chaque conducteur en résolvant à l'aide des mathématiques, les équations physiques qui régissent le phénomène de diaphonie. Cette solution s'avère rédhibitoire pour un circuit comportant un grand nombre de conducteurs, car bien que dénombrable, l'ensemble des variations de signaux possibles dans un circuit à très haute densité d'intégration est de dimension quasi infinie. La détermination des instants de commutation, nécessaire à s'assurer que ceux-ci tiennent dans un cycle d'horloge, pose donc un problème.

L'article de Takayasu et al. intitulé "Simple expressions for interconnection delay, coupling and crosstalk in VLSI's" et paru dans le volume 4, "VLSI design and CAD", de la publication "1991 IEEE INTERNATIONAL SYMPOSIUM ON CIRCUITS AND SYSTEMS", 11-14 juin 1991, pages 2375-2378, présente des expressions ou formules mathématiques pour évaluer un retard avec lequel un signal franchit un seuil de commutation sur un conducteur de résistance R et de capacité C. Ce retard résulte de la constante de temps RC du conducteur. L'objectif de l'article est d'utiliser ces formules pour optimiser les dimensions du conducteur lors de la conception d'un circuit intégré, en minimisant sa constante de temps RC du conducteur.

Le document US-A-5687088 présente un procédé de simulation de circuit logique, qui consiste à ajouter à une liste de connectique (netlist) des informations supplémentaires fournissant un délai de commutation sur un conducteur particulier. Ce délai tient compte des capacités de couplage avec d'autres conducteurs et est commandé par un état de commutation des autres conducteurs au moment de la commutation du conducteur particulier. Ce procédé applique au circuit logique une combinaison de signaux, dont l'évolution des signaux résultants dans le circuit est suivie de porte en porte. Il est exhaustif lorsque toutes les combinaisons possibles des signaux en entrée du circuit sont envisagées.

Le document US-A-5481695 présente un procédé pour estimer la diaphonie entre conducteurs de signaux d'un circuit. Le procédé s'apparente au précédent, du fait qu'il analyse les interférences entre signaux en considérant un instant d'émission sur chaque conducteur. Cet instant est fourni par un simulateur logique, découplé de l'analyseur de diaphonie.

Pour pallier les problèmes précédemment cités, l'objet de l'invention est un procédé d'évaluation de performances de circuit à très haute intégration, tel que défini par la revendication 1.

Un premier avantage de l'invention est de se ramener à une solution simple par introduction de coefficients de pondération, avantageusement paramétrables pour tenir compte de la structure du circuit. Les constantes de temps sont alors produites de façon classique. Les coefficients de pondération pourraient avoir des valeurs constantes, prédéterminées à l'aide de considérations statistiques ou de divers calculs préalables.

Une autre solution est de définir les coefficients de pondération comme étant à valeurs variables.

Un avantage supplémentaire est procuré lorsque le procédé d'évaluation de performances de circuit à très haute intégration a les caractéristiques définies dans la revendication 2.

On obtient ainsi une interaction supplémentaire du procédé avec un comportement qui se rapproche du comportement réel du circuit, ceci avec d'autant plus de précision que la quantité d'information sur ce comportement réel est significative. Un manque d'information précise sur le comportement réel du circuit n'empêche pas la mise en oeuvre de la troisième étape. En rebouclant la deuxième étape sur la troisième étape, il est par exemple possible d'enrichir la quantité d'information disponible dans la troisième étape. Différentes réitérations des trois étapes permettent alors de se rapprocher au mieux du comportement réel du circuit.

L'invention a aussi pour objets un dispositif particulièrement adapté à la mise en oeuvre du procédé d'évaluation de performances, tel que défini par la revendication 5, et l'utilisation du procédé d'évaluation de performances pour réaliser des circuits rapides à très haute intégration, telle que définie par la revendication 9, ainsi qu'un programme d'ordinateur tel que défini par la revendication 10.

D'autres détails seront mieux compris à l'aide de la description d'un mode préférentiel de mise en oeuvre de l'invention, dont l'exemple suit en référence aux figures.

- La figure 1a expose schématiquement une coupe de circuit à haute intensité d'intégration tel qu'on en rencontrait habituellement jusqu'à présent.

- La figure 1b expose schématiquement une coupe de circuit à haute intensité d'intégration tel que les technologies actuelles de dépôt multicouches en permettent la réalisation.

- La figure 2 expose un exemple simplifié de conducteurs électriques avec capacités de couplage.

- La figure 3 met en évidence différentes évolutions de potentiel d'un conducteur en fonction de l'état électrique du schéma de la figure 2.

- La figure 4 présente un exemple de circuit élémentaire à l'intérieur d'un circuit intégré.

- La figure 5 est un chronogramme pour représenter des instants de franchissement de seuil de commutation.

- La figure 6 présente un procédé pour obtenir les instants de commutation des éléments d'un circuit électrique.

- La figure 7 présente une utilisation de l'invention dans un procédé de réalisation de circuits rapides à haute intégration.

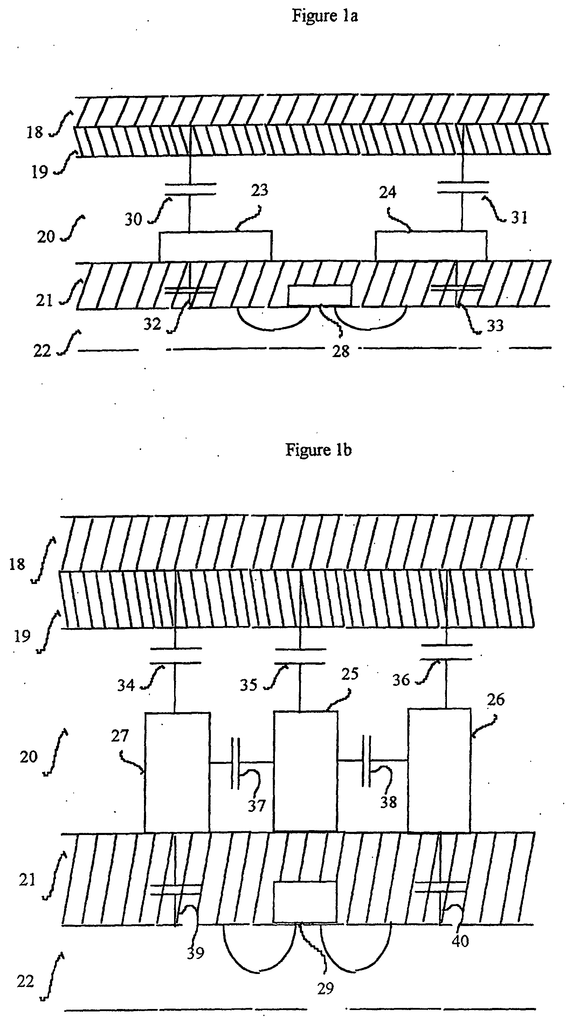

La figure 1a expose schématiquement une coupe de circuit à haute intensité d'intégration tel qu'on en rencontrait habituellement jusqu'à présent. Sur un substrat polycristallin 22, sont réalisés des microéléments 28 tels que diodes, résistances ou transistors, dans une couche d'oxyde 21. La couche 21 est surmontée par une couche métallique 20 où cheminent des conducteurs de section 23, 24. La couche 20 est surmontée par une couche 19 d'oxyde, couverte par une couche métallique 18, mise à un potentiel fixe Vss ou Vdd. Les couches précédemment décrites peuvent être répétées par superposition de façon à obtenir des circuits multicouches. Le conducteur de section 23 présente une capacité de couplage 30 avec la couche métallique 18 et une capacité de couplage 32 avec le substrat 22. Le conducteur de section 24 présente une capacité de couplage 31 avec la couche métallique 18 et une capacité de couplage 33 avec le substrat 22. La hauteur des sections 23, 24 est suffisamment faible et les conducteurs de section 23, 24 sont suffisamment éloignés, comparativement à la faible épaisseur des couches 19 et 21, pour négliger toute capacité de couplage entre les conducteurs de section 23, 24, devant les capacités de couplage 30, 31, 32, 33. Les couches 18 et 22 étant chacune à un potentiel fixe, par exemple Vss et Vdd, on ramène habituellement la somme des capacités 30, 32, à une capacité équivalente Cs par rapport au substrat.

La figure 1b expose schématiquement une coupe de circuit à haute intensité d'intégration tel que les technologies actuelles de dépôt multicouches en permettent la réalisation. Ces technologies offrent la possibilité d'augmenter l'épaisseur des couches 18 à 21. En réduisant la largeur de sections de conducteurs 25, 26, 27, il est possible d'augmenter la densité d'intégration de conducteurs électriques par unité de surface. Cette densité d'intégration est encore augmentée par la possibilité de réduire les distances entre conducteurs. En augmentant la hauteur des sections de conducteurs 25, 26, 27, il est possible d'en réduire la résistance électrique pour y faire circuler des densités de courant au moins égales à celles circulant dans les sections 23, 24, exposées en figure 1a. L'augmentation d'épaisseur des couches d'oxyde 19 et 21 a pour effet de réduire les valeurs de capacités de couplage 34, 35, 36 des conducteurs avec la couche métallique 18 et les valeurs de capacités de couplage 39, 40 des conducteurs avec le substrat 22. Les valeurs de capacités de couplage 37, 38, entre conducteurs de section 25 et 27, respectivement de section 25 et 26, ne sont plus négligeables et peuvent même avoir un effet prépondérant sur les capacités de couplage 34, 35, 36, 39, 40.

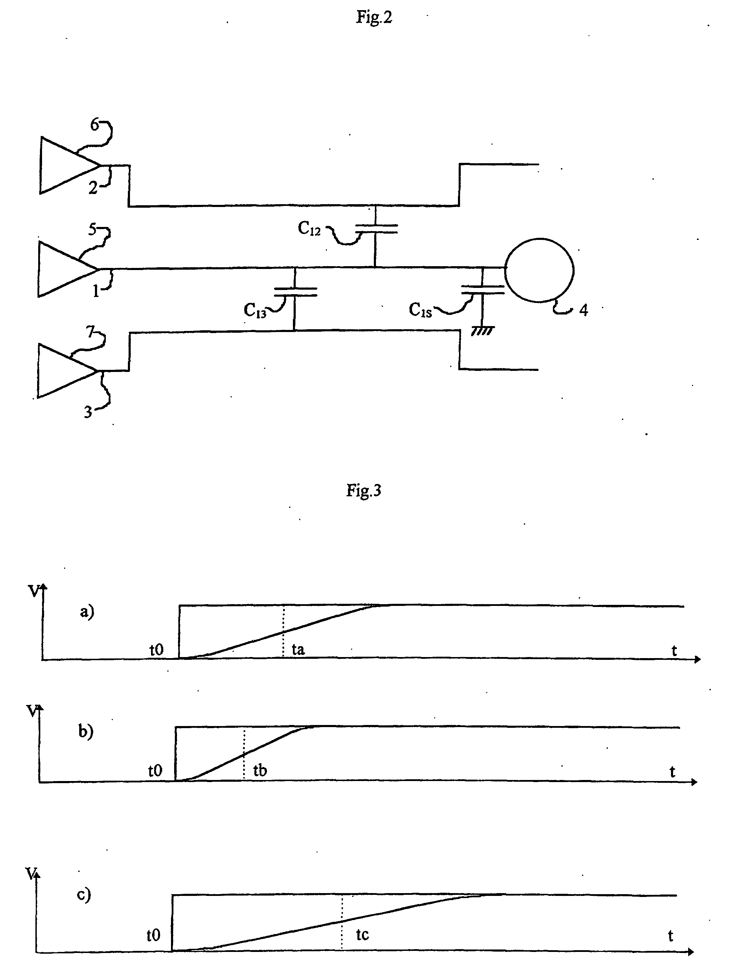

Sur la figure 2, un conducteur 1 est destiné à transmettre des signaux logiques depuis un émetteur 5 vers un récepteur 4. De même, des conducteurs 2 et 3 sont destinés à transmettre des signaux logiques respectivement depuis des émetteurs 6 et 7 vers des récepteurs non représentés. Le conducteur 1 présente une capacité $C_{1s}$ de couplage avec les potentiels fixes Vss et Vdd de référence du circuit. D'autre part, le conducteur 1 de résistance $R_1$, présente une capacité $C_{12}$ et une capacité $C_{13}$ de couplage avec respectivement le conducteur 2 et le conducteur 3. Lorsque l'émetteur 5 commute à un instant t0 sur une nouvelle valeur de potentiel, différente de celle précédent l'instant t0, le conducteur 1 atteint la nouvelle valeur de potentiel avec une constante de temps qui dépend de la résistance du conducteur 1 et du courant de charge de chacune des capacités de couplage du conducteur 1 avec les autres éléments du circuit.

La figure 3 met en évidence différentes évolutions de potentiel du conducteur 1 en fonction de l'état électrique du schéma de la figure 2.

La figure 3a) représente le cas où, de l'instant t0 auquel l'émetteur 5 commute sur la nouvelle valeur de potentiel jusqu'à un instant ta où l'atteinte d'une tension de seuil provoque une commutation du récepteur 4, les valeurs de potentiel des conducteurs 2 et 3 sont constantes. Le conducteur présente une capacité $C_T$ égale à la somme des capacités $C_{12}$, $C_{13}$ et $C_{1S}$ disposées en parallèle. La résistance $R_1$ définit une constante de temps telle que sa valeur de potentiel atteint le seuil de commutation du récepteur 4 à l'instant ta.

La figure 3b) représente le cas où, de l'instant t0 auquel l'émetteur 5 commute sur la nouvelle valeur de potentiel jusqu'à un instant tb où l'atteinte d'une tension de seuil provoque une commutation du récepteur 4, les valeurs de potentiel des conducteurs 2 et 3 évoluent de façon identique à celle du conducteur 1. Ce cas extrême se présente par exemple lorsque les conducteurs 2 et 3 ont la même valeur initiale de potentiel, et lorsque les émetteurs 6 et 7 commutent au même instant t0 que l'émetteur 5. La différence de potentiel aux bornes des capacités $C_{12}$, $C_{13}$ reste nulle à tout instant et celles-ci ne modifient donc pas leur charge. Tout se passe comme si ces capacités n'existaient pas. Le conducteur présente alors une capacité $C_T$ égale à la capacité $C_{1S}$. La résistance $R_1$ définit une constante de temps telle que la valeur de potentiel du conducteur 1 atteint le seuil de commutation du récepteur 4 à l'instant tb. L'instant tb précède l'instant ta du cas précédent car la capacité $C_T$ apparente du conducteur 1 est plus faible. La figure 3b) représente le cas dans lequel le récepteur 4 commute avec un retard tb-t0 minimal après la commutation de l'émetteur 5 car seule la capacité $C_{1S}$

agit sur la constante de temps.

La figure 3c) représente le cas où, de l'instant t0 auquel l'émetteur 5 commute sur la nouvelle valeur de potentiel jusqu'à un instant tc où l'atteinte d'une tension de seuil provoque une commutation du récepteur 4, les valeurs de potentiel des conducteurs 2 et 3 évoluent de façon inverse à celle du conducteur 1. Ce cas extrême se présente par exemple lorsque les conducteurs 2 et 3 ont une valeur initiale de potentiel inverse, et lorsque les émetteurs 6 et 7 commutent au même instant t0 que l'émetteur 5. Tout se passe sensiblement comme si les capacités $C_{12}$, $C_{13}$ avaient une valeur double de leur valeur réelle. Le conducteur présente alors une capacité $C_T$ égale à la capacité $C_{1S}$ à laquelle s'ajoute le double de la somme des capacités $C_{12}$, $C_{13}$. La résistance $R_1$ définit une constante de temps telle que la valeur de potentiel du conducteur 1 atteint le seuil de commutation du récepteur 4 à l'instant tc. L'instant tc succède à l'instant ta du premier cas car la capacité $C_T$ apparente du conducteur 1 est plus forte. La figure 3c) représente le cas dans lequel le récepteur 4 commute avec un retard tc-t0 maximal après la commutation de l'émetteur 5 car seule les capacités entre conducteurs agissent sensiblement pour le double de leur valeurs sur la constante de temps.

Entre les cas extrêmes représentés en figure 3b) et 3c), une infinité de cas peuvent se présenter pour lesquels l'instant où l'atteinte d'une tension de seuil provoque une commutation du récepteur 4, se situe dans l'intervalle [tb,tc]. Par exemple, si à la commutation de l'émetteur 5, l'émetteur 6 ne commute pas et l'émetteur 7 commute en sens inverse, $C_T = C_{1S} + C_{12} + 2*C_{13}$.

D'autre part, entre les cas où une capacité de couplage intervient pour une valeur nulle et celui pour lequel elle intervient pour une valeur double, il convient surtout de retenir qu'une capacité de couplage intervient pour sa valeur réelle si l'autre conducteur est à une valeur de tension stable. La capacité de couplage intervient pour une valeur inférieure à sa valeur réelle si les tensions sur les deux conducteurs évoluent dans le même sens. La capacité de couplage intervient pour une valeur supérieure à sa valeur réelle si les tensions sur les deux conducteurs évoluent en sens opposé.

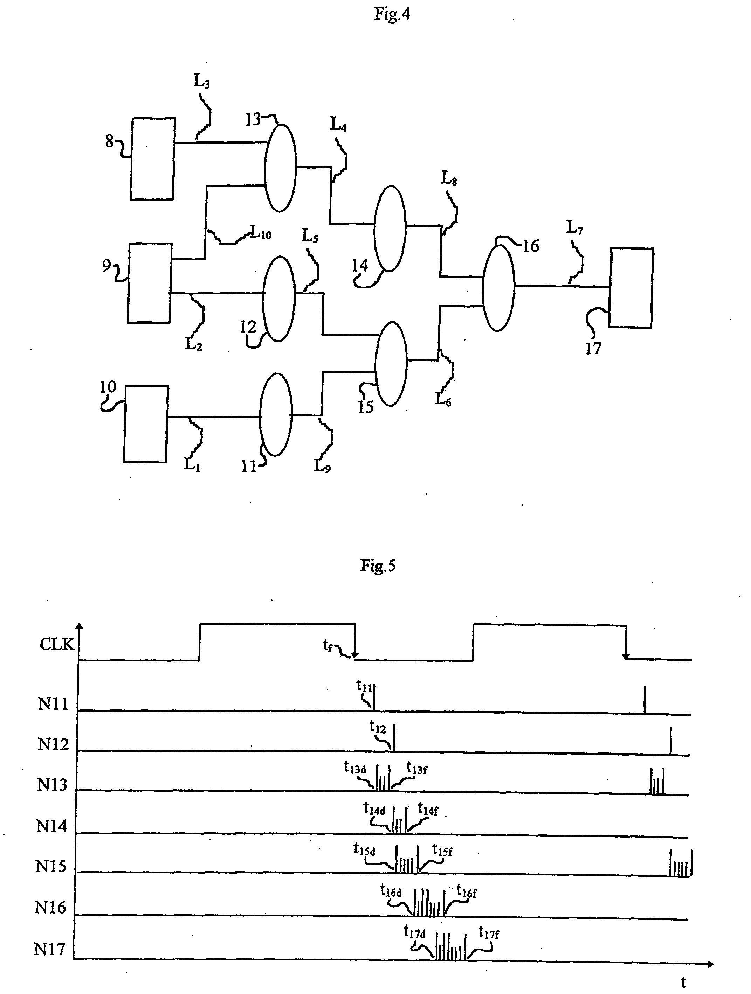

La figure 4 présente un exemple de circuit élémentaire à l'intérieur d'un circuit intégré, pour réaliser une combinaison logique de signaux issus de registres d'entrée 8, 9, 10, dont le résultat est disponible dans un registre 17. Pour simplifier les explications, on entend ici par registre tout agencement d'une ou plusieurs bascules (flip-flop en anglais). Des noeuds 11 à 16 sont composés de transistors pour obtenir en sortie de chaque noeud un signal binaire résultant de signaux d'entrée sur ce noeud. Le noeud 11 reçoit en entrée un signal issu du registre 10. Le noeud 12 reçoit en entrée un signal issu du registre 9. Le noeud 13 reçoit en entrée un signal issu du registre 8 et un signal issu du registre 9. Le noeud 14 reçoit en entrée un signal issu de la sortie du noeud 13. Le noeud 15 reçoit en entrée un signal issu de la sortie du noeud 11 et un signal issu de la sortie du noeud 12. Le noeud 16 reçoit en entrée un signal issu de la sortie du noeud 14 et un signal issu de la sortie du noeud 15. Le signal de sortie du noeud 16 est reçu en entrée du registre 17.

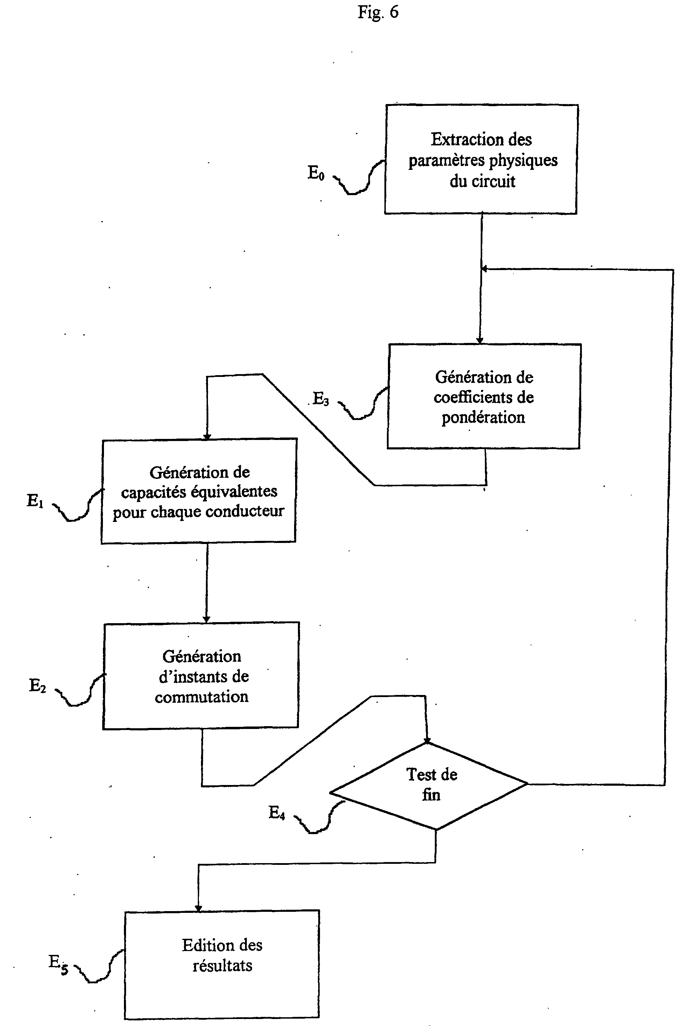

La figure 5 est un chronogramme portant le temps en abscisse de façon à représenter pour chaque élément 11 à 17 de la figure 4, les instants de franchissement de seuil de commutation, tel que défini précédemment en référence à la figure 3, en entrée de l'un de ces éléments.

La première ligne CLK représente l'état logique d'une horloge dont, par exemple, le front descendant à un instant $t_f$ détermine l'émission d'un signal binaire en sortie des registres 8 à 10.

Sur la ligne N11, le signal émis du registre 10 est susceptible de provoquer une commutation en entrée du noeud 11 à un instant $t_{11}$. Le retard $t_{11} - t_f$ résulte des capacités de couplage du conducteur reliant la sortie du registre 10 à l'entrée du noeud 11 tel qu'expliqué précédemment en référence aux figures 2 et 3.

Sur la ligne N12, le signal émis du registre 9 est susceptible de provoquer une commutation en entrée du noeud 12 à un instant $t_{12}$. Le retard $t_{12} - t_f$ résulte des capacités de couplage du conducteur reliant la sortie du registre 9 à l'entrée du noeud 12 tel qu'expliqué précédemment en référence aux figures 2 et 3.

Sur la ligne N13, le signal émis du registre 8 est susceptible de provoquer une commutation en entrée du noeud 13 à un instant $t_{13d}$. Le retard $t_{13d} - t_f$ résulte des capacités de couplage du conducteur reliant la sortie du registre 8 à l'entrée du noeud 13 tel qu'expliqué précédemment en référence aux figures 2 et 3. Le signal émis du registre 9 est susceptible de provoquer une commutation en entrée du noeud 13 à un instant $t_{13f}$. Le retard $t_{13f} - t_f$ résulte des capacités de couplage du conducteur reliant la sortie du registre 9 à l'entrée du noeud 13. Entre les instants $t_{13d}$ et $t_{13f}$, la commutation du noeud 13 est indéterminée. Cette indétermination est symbolisée par les petites hachures verticales.

Sur la ligne N14, l'indétermination de commutation du noeud 13 se reporte en entrée du noeud 14 de $t_{14d}$ à $t_{14f}$. Le retard $t_{14d} - t_{13d}$ résulte des capacités de couplage du conducteur reliant la sortie du noeud 13 à l'entrée du noeud 14 et du temps de commutation intrinsèque du noeud 13.

Sur la ligne N15, le signal émis du noeud 11 est susceptible de provoquer une commutation en entrée du noeud 15 à un instant $t_{15d}$. Le retard $t_{15d} - t_{11}$ résulte des capacités de couplage du conducteur reliant la sortie du noeud 11 à l'entrée du noeud 15 et du temps de commutation intrinsèque du noeud 11. Le signal émis du noeud 12 est susceptible de provoquer une commutation en entrée du noeud 15 à un instant $t_{15f}$. Le retard $t_{15f} - t_{12}$ résulte des capacités de couplage du conducteur reliant la sortie du noeud 12 à l'entrée du noeud 15 et du temps de commutation intrinsèque du noeud 12.

Entre les instants $t_{15d}$ et $t_{15f}$ , la commutation du noeud 15 est indéterminée. Cette indétermination est symbolisée par les petites hachures verticales.

Sur la ligne N16, l'indétermination de commutation du noeud 14 et l'indétermination de commutation du noeud 15 se reportent en entrée du noeud 16 de $t_{16d}$ à $t_{16f}$ . Le retard $t_{16d}$ - $t_{14d}$ résulte des capacités de couplage du conducteur reliant la sortie du noeud 14 à l'entrée du noeud 16 et du temps de commutation intrinsèque du noeud 14. Le retard $t_{16f}$ - $t_{15f}$ résulte des capacités de couplage du conducteur reliant la sortie du noeud 15 à l'entrée du noeud 16 et du temps de commutation intrinsèque du noeud 15.

Sur la ligne N17, l'indétermination de commutation du noeud 16 se reporte en entrée du registre 17 de $t_{17d}$ à $t_{17f}$ . Le retard $t_{17d}$ - $t_{17d}$ résulte des capacités de couplage du conducteur reliant la sortie du noeud 16 à l'entrée du registre 17 et du temps de commutation intrinsèque du noeud 16.

Les explications qui précèdent sont valables pour chaque front descendant du signal d'horloge CLK tel qu'on l'observe sur la partie droite du chronogramme.

La figure 6 présente un procédé pour obtenir les instants de commutation des éléments d'un circuit électrique.

En étape E0, les paramètres physiques du circuit sont extraits, par exemple des masques de production qui constituent une image fidèle du circuit produit à partir de ces masques. Ces paramètres physiques sont inventoriée dans une liste de connectique (netlist en anglais). L'extraction à partir des masques n'est pas nécessaire si on possède déjà une liste de connectique comprenant pour chaque conducteur électrique $L_i$ du circuit, les valeurs de sa résistance $R_i$ et des capacités réelles $C_{ij}$ existantes de couplage avec les autres conducteurs $L_j$ dont font partie la masse au potentiel fixe Vss et les conducteurs d'alimentation au potentiel fixe Vdd.

En étape E1 est générée pour chaque conducteur $L_i$ du circuit, une valeur de capacité $C_{Ti}$ équivalente de couplage par rapport à une masse de potentiel fixe. Un dispositif, tel que par exemple un ordinateur, calcule une somme des valeurs de capacités réelles $C_{ij}$ existantes de couplage de conducteurs $L_j$ du circuit avec le conducteur $L_i$. Chaque capacité $C_{ij}$ est affectée d'un coefficient de pondération $K_{ij}$.

Une étape E2 succède à l'étape E1. Un dispositif, tel que par exemple l'ordinateur utilisé en étape E1, génère un intervalle temporel de commutation $[t_{id}, t_{if}]$ sur chaque conducteur $L_i$. L'intervalle temporel de commutation $[t_{id}, t_{if}]$ généré est stocké dans une structure de données pour des traitements ultérieurs tel que par exemple, simplement une édition de résultats. Pour générer l'intervalle temporel de commutation, le dispositif calcule une constante de temps $\tau_i$ propre au conducteur $L_i$, fonction de la capacité équivalente $C_{Ti}$ générée en étape E1. Une fonction simple connue est $\tau_i = R_i \times C_{ti}$. L'instant de commutation $t_{id}$ est calculé en fonction de la constante de temps $\tau_i$ et de l'instant de la première émission en sortie de l'émetteur situé en amont du conducteur. L'instant de commutation $t_{if}$ est calculé en fonction de la constante de temps $\tau_i$ et de l'instant de la dernière émission en sortie de l'émetteur situé en amont du conducteur. Si ces instants de première et dernière émission ne sont pas déjà dans la structure de données ci-dessus mentionnée, le dispositif commence par les générer en fonction des instants de commutation des conducteurs situés en amont de l'émetteur considéré, et ainsi de suite, si besoin est, jusqu'à remonter aux bascules à l'origine des variations de signaux. Chaque émission originelle est faite à un instant $t_f$ de front d'horloge. Des valeurs de $t_{id}$ et de $t_{if}$, résultant d'un calcul strict ne correspondent pas nécessairement rigoureusement à la réalité, on peut alors retenir une valeur de $t_{id}$ légèrement inférieure à la valeur calculée et une valeur de $t_{if}$ légèrement supérieure à la valeur calculée, de façon à englober l'intervalle $[t_{id}, t_{if}]$ avec une marge d'erreur acceptable.

Pour mieux adapter les coefficients de pondération $K_{ij}$ au comportement du circuit, une étape E3 précède l'étape E1 pour générer ces coefficients de pondération. Un dispositif doté de moyens de traitement numérique scrute chaque conducteur $L_i$ dans la structure de données dont il dispose. Le dispositif scrute ensuite dans la structure de données, chaque conducteur $L_j$ ayant une capacité réelle $C_{ij}$ existante de couplage avec le conducteur $L_i$ considéré. Pour chaque paire de conducteurs $L_i$ , $L_j$ , le dispositif recherche s'il existe un intervalle temporel de commutation $[t_{id}, t_{if}]$ sur le conducteur $L_i$ et un intervalle temporel de commutation $[t_{jd}, t_{jf}]$ sur le conducteur $L_j$ avec une partie commune.

Si le dispositif ne détecte aucune information sur une existence de partie commune, il affecte une valeur unitaire au coefficient de pondération $K_{ij}$. En effet, aucune information n'existe alors selon laquelle le conducteur $L_j$ se comporte autrement que comme un conducteur à potentiel fixe pendant une commutation sur le conducteur $L_i$. Ceci est toujours le cas pour les conducteurs au potentiel fixe Vss ou Vdd.

Si le dispositif détecte une information sur l'existence d'une partie commune, il recherche si la commutation se fait sur une valeur identique pour les conducteurs $L_i$ et $L_j$ dans cette partie commune. Il est par exemple possible que ce deuxième niveau d'information soit disponible lorsque les conducteurs $L_i$ et $L_j$ véhiculent un même signal.

En absence de ce deuxième niveau d'information, le dispositif affecte au coefficient $K_{ij}$ une valeur supérieure à la valeur unitaire. En effet, aucune information n'existe alors selon laquelle une évolution de charge du conducteur $L_j$ ne s'oppose pas à une évolution de charge du conducteur $L_i$. Or, dans une évaluation de performance, il est préférable de considérer le cas le plus défavorable. En tenant compte de l'enseignement donné en référence à la figure 3, un choix simple pour la valeur du coefficient $K_{ij}$ est une valeur double.

En présence de ce deuxième niveau d'information, le dispositif affecte au coefficient $K_{ij}$ une valeur inférieure à la valeur unitaire. En effet, une information existe alors selon laquelle une évolution de charge du conducteur $L_j$ ne s'oppose pas, voire contribue à une évolution de charge du conducteur $L_i$. Or, dans une évaluation de performance, il est préférable de tenir compte d'un cas favorable pour ne pas sous évaluer à tors cette performance. En tenant compte de l'enseignement donné en référence à la figure 3, un choix simple pour la valeur du coefficient $K_{ij}$ est une valeur nulle.

L'étape E3 est d'autant plus performante que la quantité d'information dont elle dispose sur les intervalles de commutation, est conséquente. L'étape E2 génère des intervalles de commutation qu'il est intéressant d'utiliser dans l'étape E3. Une amélioration du procédé décrit consiste à reboucler la sortie de l'étape E2 sur l'entrée de l'étape E3. Une étape E4 est intercalée entre les étapes E2 et E3, de façon à pouvoir sortir de la boucle ainsi constituée par les étapes E1 à E3.

L'étape E4 constitue un test de fin, qui en cas de rupture de la boucle, amène à une étape E5 pour éditer les intervalles de commutation générés en étape E2. Différents tests peuvent être envisagés en étape E4. On peut par exemple utiliser l'incrémentation d'un compteur à chaque passage dans l'étape E4 et déclencher un signal de fin lorsque le contenu de ce compteur dépasse une valeur de seuil prédéterminée. On peut encore comparer un ou plusieurs instants de commutation, par exemple le plus tardif après le front d'horloge, généré avant le branchement précédent sur l'étape E3, à celui généré en sortie de l'étape E2, et déclencher un signal de fin si les deux instant ne diffèrent pas plus que d'une quantité prédéterminée. Tous les tests imaginables sont possibles sans sortir du cadre de la présente invention.

On peut envisager que l'enchaînement des étapes E3 à E2 se fait après avoir systématiquement scruté l'ensemble des conducteurs du circuit dans chacune des étapes E3, E1, E2. On peut aussi envisager que l'enchaînement des étapes E3 à E2 se fait après avoir scruté les conducteurs ayant une capacité de couplage avec un conducteur considéré. Les rebouclages par l'étape E4 se font alors de proche en proche jusqu'à scruter l'ensemble des conducteurs du circuit.

Regardons à présent comment le procédé décrit en référence à la figure 6 peut fonctionner sur un circuit du type de celui décrit en référence à la figure 4.

En étape E0, chacun des conducteurs $L_i$, $L_j$, les indices i et j variant de 1 au nombre total de conducteurs du circuit, dix dans le cas exposé en figure 4, est répertorié dans une structure de donnée avec ses caractéristiques physiques.

Au passage de l'étape E0 à l'étape E3, aucun intervalle de commutation n'est connu a priori. En étape E3, les coefficients de pondération sont donc tous initialisés à une valeur unitaire.

En étape E1, la capacité de couplage de chaque conducteur est alors calculée par une première approximation qui consiste à supposer que, lorsqu'un conducteur considéré $L_i$ commute, aucun autre conducteur $L_j$ voisin ne commute. Comme expliqué en référence aux figures 2 et 3, la capacité totale $C_{Ti}$ de couplage ramenée au substrat est égale à la somme de la capacité réelle de couplage au substrat $C_{Si}$ et des capacités $C_{ij}$ de couplage du conducteur $L_i$ aux n conducteurs $L_j$ voisins.

$$C_{Ti} = C_{Si} + \Sigma \, C_{ij}$$

(j≠i, j allant de 1 à n, n≤10)

En étape E2, les instants et les intervalles de commutation succédant à un instant déterminé $t_f$ de front d'horloge, sont calculés pour chaque noeud du circuit analysé, sur un modèle conforme aux explications de la figure 3, à partir de la capacité $C_{Ti}$ calculée à l'étape E1. On obtient ainsi des résultats similaires à ceux de la figure 5.

L'étape E4 rebranche ensuite le procédé sur l'étape E3 où les coefficients de pondération sont recalculés.

La combinaison des étapes E3 et E1 génère à nouveau une capacité $C_{Ti}$ pour chaque conducteur joignant deux noeuds en utilisant les résultats précédants de l'étape E2. Prenons par exemple le cas de la figure 5.

Pour recalculer la capacité $C_{T1}$ du conducteur L1, tous les conducteurs Lj avec lesquels le conducteur L1 a une capacité de couplage $C_{1j}$ sont considérés. Dans l'intervalle de temps $[t_{11} - t_f]$ d'émission d'un signal sur le conducteur L1, des signaux de signe inconnu sont émis sur les conducteurs L2, L10 et L3. Aucun signal n'est émis sur les conducteurs L4 à L9. La capacité maximale de couplage $C_{T1}$ est donnée par la formule:

$$C_{T1} = C_{S1} + 2(C_{12} + C_{13} + C_{110})$$

Pour recalculer la capacité $C_{T2}$ du conducteur L2, tous les conducteurs Lj avec lesquels le conducteur L2 a une capacité de couplage $C_{2j}$ sont considérés. Dans l'intervalle de temps $[t_{12} - t_f]$ d'émission d'un signal sur le conducteur L2, un signal de même signe est émis sur le conducteur L10, des signaux de signe inconnu sont émis sur les conducteurs L1, L3, L4 et L9. Aucun signal n'est émis sur les conducteurs L5 à L8. La capacité maximale de couplage $C_{T2}$ est donnée par la formule:

$$C_{T2} = C_{S2} + C_{210} + 2(C_{21} + C_{23} + C_{24} + C_{29})$$

Pour recalculer la capacité $C_{T3}$ du conducteur L3, tous les conducteurs Lj avec lesquels le conducteur L3 a une capacité de couplage $C_{3j}$ sont considérés. Dans l'intervalle de temps $[t_{13d} - t_f]$ d'émission d'un signal sur le conducteur L2, des signaux de signe inconnu sont émis sur les conducteurs L1, L2, L10 et L9. Aucun signal n'est émis sur les conducteurs L4 à L8. La capacité maximale de couplage $C_{T2}$ est donnée par la formule:

$$C_{T3} = C_{S3} + 2(C_{310} + C_{32} + C_{31} + C_{39})$$

Et ainsi de suite jusqu'au conducteur L7.

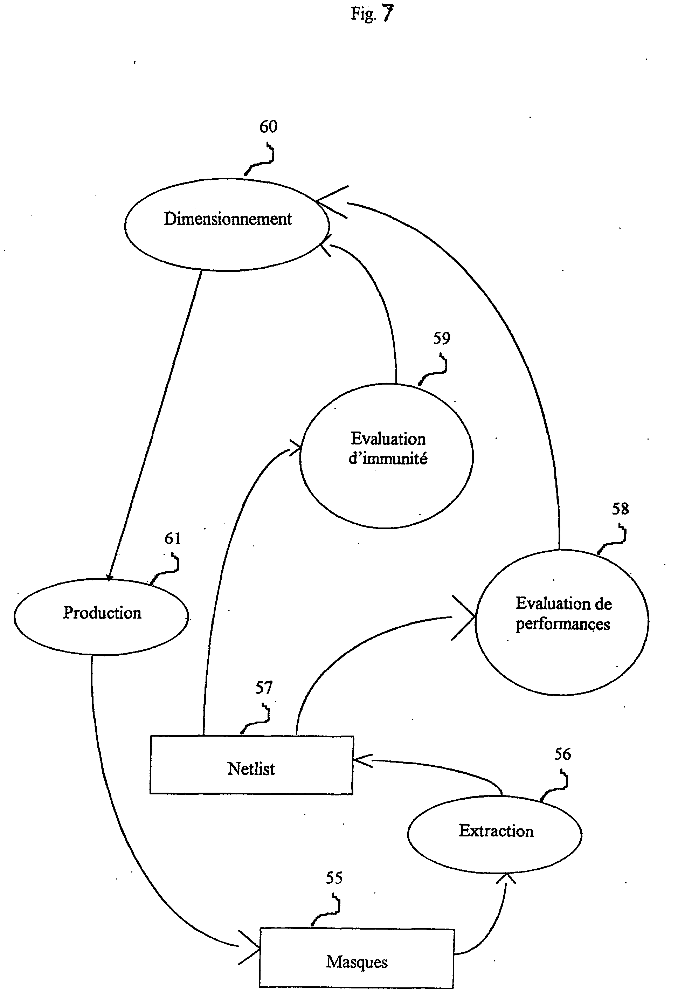

La figure 7 présente une utilisation de l'invention dans un procédé de réalisation de circuits rapides à haute intégration. Un circuit intégré est communément gravé dans un matériau semi-conducteur à partir de masques 55. Les masques 55 représentent donc une image fidèle de la structure physique du circuit. Une phase d'extraction 56 permet d'obtenir à partir des masques, une liste de connectique 57 qui contient, sous forme d'une structure de données informatique, une liste de tous les conducteurs du circuit et des noeuds que ces conducteurs relient entre eux. La liste contient aussi les caractéristiques physiques de ces conducteurs et de ces noeuds. Ces caractéristiques physiques permettent de déterminer par exemple, la résistance RL et les capacités de couplage de chaque conducteur, le seuil de commutation, l'immunité et la puissance d'émission de chaque noeud.

A partir de la liste de connectique 57, une phase 58 d'évaluation de performances utilise avantageusement les étapes E1 à E5. Si aucun intervalle temporel de commutation édité en étape E5 ne dépasse un cycle d'horloge, on est assuré que le circuit tient les objectifs de performance en rapidité qu'on s'est fixé. Dans le cas contraire, on utilise les résultats de l'étape E5 pour redimensionner le circuit dans une phase 60.

A partir de la liste de connectique 57, une phase 59 d'évaluation d'immunité consiste à déterminer le ou les noeuds récepteurs du circuits dont l'immunité est trop faible pour résister aux bruits de diaphonie. A chacun de ces noeuds est associé le conducteur amené en amont sur son entrée. Si aucun noeud ne contient de noeuds inaptes à résister aux bruits de diaphonie, on est assuré que le circuit ne propage pas de bruits de diaphonie. Dans le cas contraire, on redimensionne le circuit dans une phase 60. La phase 58 peut précéder la phase 59, de façon à bénéficier des instants de commutation générés en étape E2.

Si les phases 58 et ou 59 ne donnent pas de résultats satisfaisants quant à l'aptitude du circuit à fonctionner suffisamment rapidement et ou sans propager de bruits de diaphonie, une phase 60 de dimensionnement prévoit les actions correctrices suivantes. Pour chaque composant incriminé, conducteur ou noeud, une ou plusieurs des actions suivantes sont proposées. Une première action consiste à dimensionner le conducteur de façon à diminuer sa résistance. Ceci présente deux avantages. Le premier avantage est celui de diminuer sa constante de temps. Le second avantage est celui d'augmenter son aptitude à fournir un courant pour annuler des charges parasites provoquées par d'éventuels bruits de diaphonie.

Une deuxième action consiste à modifier le tracé du circuit de façon à diminuer les capacités de couplage avec d'autres conducteurs du circuit. Ceci présente deux avantages. Le premier avantage est celui de diminuer sa constante de temps. Le second avantage est celui de diminuer les causes de bruit d'origine diaphonique. Une troisième action consiste à dimensionner le noeud récepteur branché en aval du conducteur de façon à augmenter son immunité Im. Une quatrième action consiste à dimensionner le noeud émetteur branché en amont du conducteur de façon à augmenter sa puissance.

Suite à la phase 60, une phase 61 de production génère de nouveaux masques 55 qui incorporent tout dimensionnement effectué en phase 60. Il est possible de réitérer tout ou partie des phases 56 à 61 sur les nouveaux masques ainsi générés jusqu'à ce que la phase 60 devienne inutile. Les derniers masques générés en phase 61 permettent de réaliser des circuits rapides à très haute intégration.

**Revendications**

1. Procédé d'évaluation de performances d'un circuit à très haute intégration, incluant une première étape (E1) dans laquelle est générée, pour chaque conducteur ($L_i$) dudit circuit, une valeur de capacité ($C_{Ti}$) équivalente de couplage par rapport à une masse de potentiel fixe, comme étant une somme des valeurs de capacités réelles ($C_{ij}$) existantes de couplage de conducteurs ($L_j$) dudit circuit avec ledit conducteur ($L_i$), **caractérisé en ce que** lesdites valeurs de capacités réelles existantes sont affectées chacune d'un coefficient de pondération ($K_{ij}$) et **en ce que** la première étape est suivie d'une seconde étape (E2) dans laquelle est généré un intervalle temporel de commutation ([$t_{id}$,$t_{if}$]) sur chaque conducteur ($L_i$), ledit intervalle temporel de commutation débutant à un premier instant ($t_{id}$) avec un retard sur un instant de première émission et terminant à un deuxième instant ($t_{if}$) avec ledit retard sur un instant de deuxième émission sur ledit conducteur ($L_i$), ledit retard étant fonction de ladite capacité équivalente ($C_{Ti}$).

2. Procédé selon la revendication 1, **caractérisé en ce qu'**il comprend une troisième étape (E3) précédant ladite première étape (E1), dans laquelle est généré chacun des coefficients ($K_{ij}$) comme étant égal à :

- une valeur unitaire en absence d'information selon laquelle un intervalle temporel de commutation ([$t_{jd}$,$t_{jf}$]) sur le conducteur ($L_j$) ayant

une capacité réelle ($C_{ij}$) existante de couplage avec le conducteur ($L_i$) possède une partie commune avec l'intervalle temporel de commutation ($[t_{id}, t_{if}]$) sur le conducteur ($L_i$) ;

- une valeur supérieure à ladite valeur unitaire en présence d'information selon laquelle un intervalle temporel de commutation ($[t_{jd}, t_{jf}]$) sur le conducteur ($L_j$) ayant une capacité réelle ($C_{ij}$) existante de couplage avec le conducteur ($L_i$) possède une partie commune avec l'intervalle temporel de commutation ($[t_{id}, t_{if}]$) sur le conducteur ($L;$), et en absence d'information selon laquelle la commutation se fait sur une valeur identique pour les conducteurs ($L_i$) et ($L_j$) dans ladite partie commune ;

- une valeur inférieure à ladite valeur unitaire en présence d'information selon laquelle un intervalle temporel de commutation ($[t_{jd}, t_{jf}]$) sur le conducteur ($L_j$) ayant une capacité réelle ($C_{ij}$) existante de couplage avec le conducteur ($L_i$) possède une partie commune avec l'intervalle temporel de commutation ($[t_{id}, t_{if}]$) sur le conducteur ($L_i$), et en présence d'information selon laquelle la commutation se fait sur une valeur identique pour les conducteurs ($L_i$) et ($L_j$) dans ladite partie commune.

3. Procédé selon la revendication 2, **caractérisé en ce que** ladite valeur supérieure est égale à deux et ladite valeur inférieure est nulle.

4. Procédé selon la revendication 2 ou 3, **caractérisé en ce qu'**il comprend une quatrième étape (E4) pour tester si le procédé est fini et, s'il ne l'est pas, pour reboucler la sortie de la deuxième étape (E2) sur l'entrée de la troisième étape (E3).

5. Dispositif d'évaluation de performances d'un circuit à très haute intégration, incluant des premiers moyens pour calculer, pour chaque conducteur ($L_i$) dudit circuit, une valeur de capacité ($C_{Ti}$) équivalente de couplage par rapport à une masse de potentiel fixe, comme étant une somme des valeurs de capacités réelles ($C_{ij}$) existantes de couplage de conducteurs ($L_j$) dudit circuit avec ledit conducteur ($L_i$), **caractérisé en ce que** lesdites valeurs de capacités réelles existantes sont affectées chacune d'un coefficient de pondération ($K_{ij}$) et **en ce que** le dispositif comprend en outre des seconds moyens pour calculer un intervalle temporel de commutation ($[t_{id}, t_{if}]$) sur chaque conducteur ($L_i$), ledit intervalle temporel de commutation débutant à un premier instant ($t_{id}$) avec un retard sur un instant de première émission et terminant à un deuxième instant ($t_{if}$) avec ledit retard sur un instant de deuxième émission sur ledit conducteur ($L_i$), ledit retard étant fonction de ladite capacité équivalente ($C_{Ti}$).

6. Dispositif selon la revendication 5, **caractérisé en ce qu'**il comprend des troisièmes moyens pour calculer chacun des coefficients ($K_{ij}$) comme étant égal à

- une valeur unitaire si le dispositif ne dispose pas d'information selon laquelle un intervalle temporel de commutation ($[t_{jd}, t_{jf}]$) sur le conducteur ($L_j$) ayant une capacité réelle ($C_{ij}$) existante de couplage avec le conducteur ($L_i$) possède une partie commune avec l'intervalle temporel de commutation ($[t_{id}, t_{if}]$) sur le conducteur ($L_i$) ;

- une valeur supérieure à ladite valeur unitaire si le dispositif dispose d'une information selon laquelle un intervalle temporel de commutation ($[t_{jd}, t_{jf}]$) sur le conducteur ($L_j$) ayant une capacité réelle ($C_{ij}$) existante de couplage avec le conducteur ($L_i$) possède une partie commune avec l'intervalle temporel de commutation ($[t_{id}, t_{if}]$) sur le conducteur ($L_i$), le dispositif ne disposant pas d'information selon laquelle la commutation se fait sur une valeur identique pour les conducteurs ($L_i$) et ($L_j$) dans ladite partie commune ;

- une valeur inférieure à ladite valeur unitaire si le dispositif dispose d'une information selon laquelle un intervalle temporel de commutation ($[t_{jd}, t_{jf}]$) sur le conducteur ($L_j$) ayant une capacité réelle ($C_{ij}$) existante de couplage avec le conducteur ($L_i$) possède une partie commune avec l'intervalle temporel de commutation ($[t_{id}, t_{if}]$) sur le conducteur ($L_i$), le dispositif disposant d'une information selon laquelle la commutation se fait sur une valeur identique pour les conducteurs ($L_i$) et ($L_j$) dans ladite partie commune.

7. Dispositif selon la revendication 6, **caractérisé en ce que** ladite valeur supérieure est égale à deux et en ladite valeur inférieure est nulle.

8. Dispositif selon la revendication 6 ou 7, **caractérisé en ce qu'**il comprend des quatrièmes moyens pour tester si oui ou non les informations générées par les seconds moyens sont à reboucler sur les premiers moyens.

9. Procédé de réalisation d'un circuit électrique, incluant une phase (61) de production de masques (55) et **caractérisé en ce qu'**il comprend :

- une phase d'évaluation (58) des composants des masques, dans laquelle est mis en oeuvre le procédé suivant l'une des revendications 1 à 4 ;

- une phase de dimensionnement (60) pour dimensionner tout ou partie des composants incriminés dans la phase d'évaluation (58) ; et

- une réitération de la phase (61) avec les composants dimensionnés en phase (60).

**10.** Programme d'ordinateur comprenant des portions/ moyens/instructions de code de programme pour l'exécution des étapes du procédé selon l'une des revendications 1 à 4 et 9 lorsque ledit programme est exécuté sur un ordinateur.

**Patentansprüche**

**1.** Verfahren zum Bewerten der Leistungsfähigkeit einer Schaltung mit sehr hoher Integration, mit einem ersten Schritt (E1), bei dem für jeden Leiter (L;) der Schaltung ein äquivalenter Kopplungskapazitätswert ($C_{Ti}$) in bezug auf eine Masse mit festem Potential als Summe von vorhandenen wirklichen Kopplungskapazitäten ($C_{ij}$) von Leitern ($L_j$) der Schaltung mit diesem Leiter ($L_i$) erzeugt wird, **dadurch gekennzeichnet, daß** die vorhandenen wirklichen Kapazitätswerte jeweils mit einem Gewichtungskoeffizienten ($K_{ij}$) versehen werden und daß dem ersten Schritt ein zweiter Schritt (E2) folgt, bei dem ein Zeitintervall ($[t_{id}, t_{if}]$) der Aufschaltung auf jeden Leiter ($L_i$) erzeugt wird, das zu einem ersten Zeitpunkt ($t_{id}$) mit einer Verzögerung bezüglich eines Zeitpunkts des ersten Sendens beginnt und zu einem zweiten Zeitpunkt ($t_{if}$) mit dieser Verzögerung bezüglich eines Zeitpunkts des zweiten Sendens auf dem Leiter ($L_i$) endet, wobei die Verzögerung von der äquivalenten Kapazität ($C_{Ti}$) abhängt.

**2.** Verfahren nach Anspruch 1, **dadurch gekennzeichnet, daß** es einen dritten Schritt (E3) umfaßt, der dem ersten Schritt (E1) vorhergeht und bei dem jeder der Koeffizienten ($K_{ij}$) erzeugt wird als:

- ein Einheitswert bei Abwesenheit von Informationen, gemäß denen ein Zeitintervall ($[t_{jd}, t_{jf}]$) der Aufschaltung auf den Leiter ($L_j$), der eine vorhandene wirkliche Kopplungskapazität ($C_{ij}$) mit dem Leiter ($L_i$) hat, einen gemeinsamen Abschnitt mit dem Zeitintervall ($[t_{id}, t_{if}]$) der Aufschaltung auf den Leiter ($L_i$) besitzt;

- ein Wert, der größer als der Einheitswert ist, wenn Informationen vorhanden sind, gemäß denen ein Zeitintervall ($[t_{jd}, t_{jf}]$) der Aufschaltung auf den Leiter ($L_j$), der eine vorhandene wirkliche Kopplungskapazität ($C_{ij}$) mit dem Leiter (L;) hat, einen gemeinsamen Abschnitt mit dem Zeitintervall ($[t_{id}, t_{if}]$) der Aufschaltung auf den Leiter ($L_i$) hat und wenn Informationen, gemäß denen das Schalten in dem gemeinsamen Abschnitt für die Leiter ($L_i$) und ($L_j$) mit dem gleichen Wert erfolgt, nicht vorhanden sind;

- ein Wert, der kleiner als der Einheitswert ist, wenn Informationen vorhanden sind, gemäß denen ein Zeitintervall ($[t_{jd}, t_{jf}]$) der Aufschaltung auf den Leiter ($L_j$), der eine wirklich vorhandene Kopplungskapazität ($C_{ij}$) mit dem Leiter ($L_i$) besitzt, einen gemeinsamen Abschnitt mit dem Zeitintervall ($[t_{id}, t_{if}]$) der Aufschaltung auf den Leiter ($L_i$) besitzt, und wenn Informationen vorhanden sind, gemäß denen das Schalten in dem gemeinsamen Abschnitt für die Leiter ($L_i$) und ($L_j$) mit dem gleichen Wert erfolgt.

**3.** Verfahren nach Anspruch 2, **dadurch gekennzeichnet, daß** der größere Wert gleich zwei ist und der kleinere Wert gleich null ist.

**4.** Verfahren nach Anspruch 2 oder 3, **dadurch gekennzeichnet, daß** es einen vierten Schritt (E4) umfaßt, bei dem geprüft wird, ob das Verfahren beendet ist, und bei dem, wenn dies nicht der Fall ist, der Ausgang des zweiten Schrittes (E2) zum Eingang des dritten Schrittes (E3) zurückgeschleift wird.

**5.** Vorrichtung zum Bewerten der Leistungsfähigkeit einer Schaltung mit sehr hoher Integration, mit ersten Mitteln, die für jeden Leiter ($L_i$) der Schaltung einen äquivalenten Kopplungskapazitätswert ($C_{Ti}$) in bezug auf eine Masse mit festem Potential als eine Summe von vorhandenen wirklichen Kopplungskapazitätswerten von Leitern ($L_j$) der Schaltung mit diesem Leiter ($L_i$) berechnen, **dadurch gekennzeichnet, daß** die vorhandenen wirklichen Kapazitätswerte jeweils mit einem Gewichtungskoeffizienten ($K_{ij}$) versehen sind und daß die Vorrichtung außerdem zweite Mittel umfaßt, die ein Zeitintervall ($[t_{id}, t_{if}]$) der Aufschaltung auf den Leiter ($L_i$) berechnen, das zu einem ersten Zeitpunkt ($t_{id}$) mit einer Verzögerung bezüglich eines Zeitpunkts des ersten Sendens beginnt und zu einem zweiten Zeitpunkt ($t_{if}$) mit dieser Verzögerung bezüglich eines Zeitpunkts des zweiten Sendens auf dem Leiter (L;) endet, wobei die Verzögerung von der äquivalenten Kapazität ($C_{Ti}$) abhängt.

**6.** Vorrichtung nach Anspruch 5, **dadurch gekennzeichnet, daß** sie dritte Mittel umfaßt, die jeden der Koeffizienten ($K_{ij}$) berechnen als

- einen Einheitswert, falls die Vorrichtung keine Informationen liefert, gemäß denen ein Zeitintervall ($[t_{jd}, t_{jf}]$) der Aufschaltung auf den Leiter ($L_j$), der eine vorhandene wirkliche Kopplungskapazität ($C_{ij}$) mit dem Leiter (L;) hat, einen gemeinsamen Abschnitt mit dem Zeitintervall ($[t_{id}, t_{if}]$) der Aufschaltung auf den Leiter (L;) besitzt;

- einen Wert, der größer als der Einheitswert ist, falls die Vorrichtung Informationen liefert, gemäß denen ein Zeitintervall ($[t_{jd}, t_{jf}]$) der Aufschaltung auf den Leiter ($L_j$), der eine vorhandene wirkliche Kopplungskapazität ($C_{ij}$) mit dem Leiter ($L_;$) hat, einen gemeinsamen Abschnitt mit dem Zeitintervall ($[t_{id}, t_{if}]$) der Aufschaltung auf den Leiter ($L_;$) besitzt, und falls die Vorrichtung keine Informationen liefert, gemäß denen das Schalten in dem gemeinsamen Abschnitt für die Leiter ($L_i$) und ($L_j$) mit demselben Wert erfolgt;

- einen Wert, der kleiner als der Einheitswert ist, falls die Vorrichtung Informationen bereitstellt, gemäß denen ein Zeitintervall ($[t_{jd}, t_{jf}]$) der Aufschaltung auf den Leiter ($L_j$), der eine vorhandene wirkliche Kopplungskapazität ($C_{ij}$) mit dem Leiter ($L_;$) hat, einen gemeinsamen Abschnitt mit dem Zeitintervall ($[t_{id}, t_{if}]$) der Aufschaltung auf den Leiter ($L_;$) besitzt, und falls die Vorrichtung Informationen bereitstellt, gemäß denen das Schalten in dem gemeinsamen Abschnitt für die Leiter ($L_;$) und $L_j$) mit demselben Wert erfolgt.

**7.** Vorrichtung nach Anspruch 6, **dadurch gekennzeichnet, daß** der größere Wert gleich zwei ist und der kleinere Wert gleich null ist.

**8.** Vorrichtung nach Anspruch 6 oder 7, **dadurch gekennzeichnet, daß** sie vierte Mittel umfaßt, die prüfen, ob die von den zweiten Mitteln erzeugten Informationen zu den ersten Mitteln zurückgeschleift werden sollen oder nicht.

**9.** Verfahren für die Verwirklichung einer elektrischen Schaltung, das eine Phase (61) für die Produktion von Masken (55) enthält und **dadurch gekennzeichnet ist, daß** es umfaßt:

- eine Phase (58) der Bewertung von Maskenbestandteilen, in der das Verfahren nach einem der Ansprüche 1 bis 4 ausgeführt wird;

- eine Dimensionierungsphase (60), in der alle oder einige der Bestandteile, die in der Bewertungsphase (58) beanstandet wurden, dimensioniert werden; und

- eine Wiederholung der Phase (61) mit den in der Phase (60) dimensionierten Bestandteilen.

**10.** Computerprogramm, das Programmcode-Abschnitte/-Mittel/-Befehle für die Ausführung der Schritte des Verfahrens nach einem der Ansprüche 1 bis 4 und 9, wenn das Programm auf einem Computer ausgeführt wird, umfaßt.

**Claims**

**1.** Method for evaluating the performance of a very large-scale integration circuit, including a first step (E1) in which, for each lead ($L_i$) of said circuit, a value for equivalent capacitance ($C_{Ti}$) for coupling relative to a fixed-potential earth is generated, as being a sum of the existing actual values for capacitance ($C_{ij}$) for coupling conductors ($L_j$) in said circuit to said conductor ($L_i$), **characterised in that** said existing actual capacitance values are each assigned a weighting coefficient ($K_{ij}$) and **in that** the first step is followed by a second step (E2) in which a switching time period ($[t_{id}, t_{if}]$) is generated on each conductor ($L_i$), said switching time period beginning at a first moment ($t_{id}$) with a delay from a moment of first sending and ending at a second moment ($t_{if}$) with said delay from a moment of second sending on said conductor ($L_i$), said delay being a function of said equivalent capacitance ($C_{Ti}$).

**2.** Method according to Claim 1, **characterised in that** it comprises a third step (E3) preceding said first step (E1), in which each of the coefficients ($K_{ij}$) is generated as being equal to:

a unit value in the absence of information as to whether a switching time period ($[t_{jd}, t_{jf}]$) on the conductor ($L_j$) having an existing actual capacitance ($C_{ij}$) for coupling with the conductor ($L_i$) has a part in common with the switching time period ($[t_{id}, t_{if}]$) on the conductor ($L_i$);

a value greater than said unit value in the presence of information as to whether a switching time period ($[t_{jd}, t_{jf}]$) on the conductor ($L_j$) having an existing actual capacitance ($C_{ij}$) for coupling with the conductor ($L_i$) has a part in common with the switching time period ($[t_{id}, t_{if}]$) on the conductor ($L_i$), and in the absence of information as to whether the switching takes place on an identical value for the conductors ($L_i$) and ($L_j$) in said part in common;

a value less than said unit value in the presence of information as to whether a switching time period ($[t_{jd}, t_{jf}]$) on the conductor ($L_j$) having an existing actual capacitance ($C_{ij}$) for coupling with the conductor ($L_i$) has a part in common with the switching time period ($[t_{id}, t_{if}]$) on the conductor ($L_i$), and in the presence of information as to whether the switching takes place on an identical value for the conductors ($L_;$) and ($L_j$) in said part in common.

**3.** Method according to Claim 2, **characterised in that** said greater value is equal to two and said lesser value is zero.

**4.** Method according to Claim 2 or 3, **characterised in that** it comprises a fourth step (E4) for testing whether the method is finished and, if not, for looping the output of the second step (E2) back to the input of the third step (E3).

**5.** Device for evaluating the performance of a very large-scale integration circuit, including first methods for calculating, for each conductor ($L_i$) of said circuit, an equivalent value for capacitance ($C_{Ti}$) for coupling relative to a fixed-potential earth, as being a sum of the existing actual values for capacitance ($C_{ij}$) for coupling conductors ($L_j$) in said circuit to said conductor ($L_i$), **characterised in that** said existing actual capacitance values are each assigned a weighting coefficient ($K_{ij}$) and **in that** the device further comprises second means for calculating a switching time period ($[t_{id}, t_{if}]$) on each conductor ($L_i$), said switching time period beginning at a first moment ($t_{id}$) with a delay from a moment of first sending and ending at a second moment ($t_{if}$) with said delay from a moment of second sending on said conductor ($L_i$), said delay being a function of said equivalent capacitance ($C_{Ti}$).

**6.** Device according to Claim 5, **characterised in that** it comprises third means for calculating each of the coefficients ($K_{ij}$) as being equal to:

a unit value if the device has no information as to whether a switching time period ($[t_{jd}, t_{jf}]$) on the conductor ($L_j$) having an existing actual capacitance ($C_{ij}$) for coupling with the conductor ($L_i$) has a part in common with the switching time period ($[t_{id}, t_{if}]$) on the conductor ($L_i$);

a value greater than said unit value if the device has information as to whether a switching time period ($[t_{jd}, t_{jf}]$) on the conductor ($L_j$) having an existing actual capacitance ($C_{ij}$) for coupling with the conductor ($L_i$) has a part in common with the switching time period ($[t_{id}, t_{if}]$) on the conductor ($L_i$), the device having no information as to whether the switching takes place on an identical value for the conductors ($L_i$) and ($L_j$) in said part in common;

a value less than said unit value if the device has information as to whether a switching time period ($[t_{jd}, t_{jf}]$) on the conductor ($L_j$) having an existing actual capacitance ($C_{ij}$) for coupling with the conductor ($L_i$) has a part in common with the switching time period ($[t_{id}, t_{if}]$) on the conductor ($L_i$), the device having information as to whether the switching takes place on an identical value for the conductors ($L_i$) and ($L_j$) in said part in common.

**7.** Device according to Claim 6, **characterised in that** said greater value is equal to two and said lesser value is zero.

**8.** Device according to Claim 6 or 7, **characterised in that** it comprises fourth means for testing whether or not the information generated by the second means is to be looped back to the first means.

**9.** Method for producing an electrical circuit, including a phase (61) of production of masks (55) and **characterised in that** it comprises:

a phase (58) for evaluating the components of the masks, in which the method according to one of Claims 1 to 4 is implemented;

a dimensioning phase (60) for assigning dimensions to all or some of the components involved in the evaluation phase (58); and

a repeat of phase (61) with the components assigned dimensions in phase (60).

**10.** Computer program comprising program code instructions/means/portions for executing the steps in the method according to one of Claims 1 to 4 and 9 when said program is executed on a computer.

Figure 1a

Figure 1b

EP 0 932 110 B1

Fig.2

Fig.3

14

Fig.4

Fig.5

Fig. 6

$E_0$ — Extraction des paramètres physiques du circuit

$E_3$ — Génération de coefficients de pondération

$E_1$ — Génération de capacités équivalentes pour chaque conducteur

$E_2$ — Génération d'instants de commutation

$E_4$ — Test de fin

$E_5$ — Edition des résultats

Fig. 7